(19) Europäisches Patentamt

European Patent Office

Office européen des brevets

(11) **EP 1 388 015 B1**

(12) **EUROPEAN PATENT SPECIFICATION**

(45) Date of publication and mention
of the grant of the patent:
**17.08.2005 Bulletin 2005/33**

(51) Int Cl.⁷: **G01R 27/02**, G01R 27/08,
G01R 27/20

(21) Application number: **02724816.0**

(22) Date of filing: **07.05.2002**

(86) International application number:
**PCT/NO2002/000169**

(87) International publication number:
**WO 2002/091003 (14.11.2002 Gazette 2002/46)**

(54) **CONTACT CONTROL AND CONTACT MONITORING**

KONTAKTSTEUERUNG UND KONTAKTÜBERWACHUNG

COMMANDE DE CONTACT ELECTRIQUE ET SURVEILLANCE DE CONTACT

(84) Designated Contracting States:
**AT BE CH CY DE DK ES FI FR GB GR IE IT LI LU MC NL PT SE TR**

(30) Priority: **08.05.2001 NO 20012255**

(43) Date of publication of application:
**11.02.2004 Bulletin 2004/07**

(73) Proprietor: **Sintef Energiforskning AS**
**7465 Trondheim (NO)**

(72) Inventors:
• **RUNDE, Magne**
**N-7051 Trondheim (NO)**
• **LILLEVIK, Odd**
**N-7099 Flatasen (NO)**

(74) Representative: **Howe, Steven**
**Lloyd Wise**
**Commonwealth House,**
**1-19 New Oxford Street**
**London WC1A 1LW (GB)**

(56) References cited:
| | |
|---|---|
| DE-A- 2 055 477 | DE-A1- 3 632 169 |
| US-A- 3 731 189 | US-A- 3 816 812 |
| US-A- 4 104 578 | US-A- 4 801 864 |
| US-A- 6 034 531 | |

• **RUNDE M. ET AL: 'Method for detecting degraded contacts in gas insulated substations'** INTERNATIONAL CONFERENCE ELECTRICAL CONTACTS 1994, NOGOYA, JP, pages 699 - 704

## Description

This invention relates to control of the condition of electrical contacts in electrical power installations. In particular it relates to a method and device whereby accurate measurements of resistance are performed through one or more contacts at different current levels. If the resistance is constant and independent of the current, the contact is good, but a resistance that increases with increasing current or in other ways is not constant or reproducible gives a reliable indication that the contact is bad or overloaded. The invention can be used generally to control all types of electrical contacts between metallic conductors.

Overheating in the electrical contacts, i.e. the connections between conducting sections in fully encapsulated $SF_6$-isolated high voltage junction installations, that is allowed to develop may result in expensive breakdown.

Conventional techniques for condition control of contacts, i.e. thermal visual inspection and four-point resistance measurements, have limited possibilities of indicating ageing contacts inside an $SF_6$-installation at an early stage. The encapsulation shields heat radiation and if a moderate increase in resistance is measured, it is not possible to find if this is caused by a significant increase in the resistance in one contact, a smaller increase in many contacts or that that the temperature of the conductors are somewhat higher as compared to the previous measurement.

From theory of electrical contacts it is well known that such contacts which are overloaded will have a local increase in temperature in the small points of contact. At moderate overloading the contact resistance will be somewhat higher for large currents than for smaller, as the resistivity of the metal in the contact points increases with increasing temperature.

In more extreme situations the temperature of the points of contact may become so high that there will be a local melting. This may cause sudden changes of the resistance of the contact, and will generally increase dramatically the rate of chemical and metallurgical processes which contribute to the breakdown of the contact. In example, melting and corrosion processes will rapidly and irreversibly be able to transform conducting metal to oxides, sulphates or other isolating or materials with low conduction.

Conventional methods of measurements on electrical contacts in air-isolated electrical installations may in most cases measure possible damage to the electrical contacts well in advance of the occurrence of major damages. The contacts are easily available and even minor contact damages may be detected with infrared cameras or quite simply by injecting a dc current of a few hundred amperes through the contacts and measure the resulting voltage drop over each contact. However, such techniques are not well suited to finding moderate contact damage inside gas-isolated spaces.

The metal walls inhibit infrared radiation from a deteriorated contact. Conventional resistance measurements between the external contact points have limited value in that the measurements include a number of contacts in series and it is difficult to separate a dangerous increase of the resistance caused by damage to one contact from increases of the resistance caused by minor and harmless damages to a number of contacts.

Among the previously known methods of detecting deteriorated contacts it is for example known form DD 257885 Al to apply short current pulses in the microsecond range for subsequently to detect short current impulses caused by spark discharges in the deteriorated contacts.

US 5,721,688 describes an apparatus and a method of measuring in electrical systems, including battery condition, resistance in conductors, contacts and the like. The method is particularly directed to power supply systems and a current source is used which by use of a microcomputer controls the application of predetermined current signals and where measurements of the electrical voltages formed by the applied currents are measured and where at least one electrical property of the system is estimated.

It is previously known from US 3,816,812 a device for the measurement of the resistance of electrical contacts in electrical supply installations. The device comprises a pulsed current source driven by a battery which in one of its embodiments comprises rechargeable batteries and capacitor means.

Among the previously known methods of detecting bad contacts there are also methods which exploit the nonlinear current-voltage characteristics of bad contacts by applying a composite signal comprising a dc-current signal in combination with an ac-current signal resulting in fault signals, e.g. a second harmonic signal, i.e. a signal at double the frequency of the applied test signal.

US-patent 4,496,900 describes an apparatus and a method of non-destructive detection of faults in conductors which gives rise to non-linearity in the resistance by the application of currents, where the applied current signal is a composite ac- and dc-signal.

US-patent 3,500,188 describes a method and a device for measuring the electrical resistance of electrical connections by measuring the non-linearity of the resistance appearing by the application of current. A composite signal comprising an ac current signal is applied and higher harmonics of the ac current signal are found in the resulting voltage signal in the conductors to be tested.

US-patents 5,469,051 and 4,213,087 describe methods and devices for testing electrical conductor elements at the production of integrated circuits where the non-linearity of the resistance is determined. US-patent 5,496,051 describes that current signals at a first and second frequency are applied to the parts to be tested. US-patent 4,213,087 describes a method in which a train of pulses is applied to the element to be tested, after which the mean current through or the voltage over the element gives a measure of possible non-linear resistance of the element.

Further it has previously been described an alternative method by M. Runde, A. Gjelsvik and A. Rein in "Method for detecting degraded contacts in gas insulated substations", Proc. 17th Int. Conf. Electrical Contacts, Nagoya, Japan, 1994, where the current-voltage characteristic of the contacts are provided by applying pulsed alternating voltage signals of varying voltage to the contacts. However, it is mentioned that a disadvantage of this method is associated with the current supply. Even though continuous operation of the current source is not required, it is evident that a direct voltage supply which is capable of delivering the required current levels will be both large and expensive.

Supplies which deliver continuous alternating current (transformers) have been tried previously, but this gives large and heavy power supplies. Further, it has previously been tried to use batteries as a source of direct current, but this also gives an unacceptably heavy power supply.

Runde et al (1994) discussed the possibility of using pulsed direct voltage signals and measuring the current. It is mentioned that even though continuous operation of the current source is not required, a direct voltage supply which is capable of supplying several thousand amperes will be both large and expensive.

Runde et al (1994) also discussed the possibility of using alternating voltage signals together with measurement of the third harmonic component of the resulting current. It is mentioned that this method also has limitations. Due to the relatively large inductive voltage loss an even larger power supply will be required than when using a dc voltage signal. Further a calibration for non-linearity in the current supply may possibly have to be performed.

Runde et al also discloses a method for control of the condition of electrical contacts in electric power installations, particularly in installations having one or more contacts and where the whole or parts of the main current path is encapsulated or in other ways difficult to reach, such as in gas isolated connection installations, comprising applying electric current from a current supply which is connected to the main current path of said electric power installation,

measuring of the progression of the applied current,

measuring a resulting electric voltage appearing over a particular part of the main current path,

and estimating the resistance of said part on the basis of the measurements of current and voltage as an expression of the condition of the contacts,

There is also disclosed in the Runde et al document a device for the control of the condition of electrical contacts of electric power installations, particularly in installations where the whole or parts of the main current path is encapsulated or in other ways difficult to reach, such as in gas isolated connection installations comprising a current supply which is adapted to be connected to the main current path in an electric power installation.

Pulsed capacitor based current supplies are as such well known e.g. from US-patent 6,184,662 B1. However, it is not known to use such current sources in association with measurements of contact resistance.

US Patent Number 6,034,531 discloses a method of monitoring the wear of at least one sliding electrical contact of a brush sliding over a track which can move with respect to the brush comprises the measurement of the electrical resistance of this contact, the delivery of an image signal corresponding to this resistance, the following of its variations, the construction of a reference signal indicative of a state of wear of the contact, the comparison of the image signal with the reference signal and the derivation of the signal, resulting from this comparison, corresponding to the state of wear of the contact. The resistance is measured by the ratio of the variations in the voltage across the terminals of the contact to the variations in the current flowing through the contact. The described method is directed to the monitoring of the wear of at least one sliding electrical contact of a brush and the noise picture is considered to determine changes in the condition of the sliding contact.

US Patent Number 3,816,812 discloses an apparatus for measuring the resistance of a load such as circuit breaker contacts with current pulses. A control circuit for operating a digital voltmeter is arranged to operate the voltmeter only when the current pulse has a predetermined amplitude.

It is a purpose of the present invention to provide a new method and a device for control of the condition of electrical contacts in electrical power installations, particularly in installations where the contacts and the main current path is encapsulated or in other ways difficult to access, such as in gas isolated junction installations, whereby significant disadvantages of the most well known methods and devices are eliminated. The above purposes are achieved with a method which according to the present invention is characterised in that the method is arranged for control of the condition of stationary electrical contacts in electric power installations, wherein at least one current pulse has an amplitude equivalent to the rated current of the installation concerned, and

in that approximately corresponding values of the current and voltage are sampled at least in the area near the peak of the current progression and at a number of different current values, in order to form time series or sequences of samples, $i(n)$ and $u(n)$, respectively, where $1<n<N$ and where $N$ is the total number of samples in each time series, and the samples are transferred to a microprocessor or computer for calculation of the resistance.

A device for achieving the above-mentioned purposes is characterised in that the device comprises one or more capacitors for supplying at least one current pulse having an initial rising flank being significantly steeper than the rear falling flank of the current pulse where the current pulse has a peak value in a range between the flanks,

means for current measurement,

a measuring and control unit which is adapted to be connected to the current supply for supplying a control signal and for the receiving of measured current values from said means for current measurement, and

the measuring and control unit is adapted to measure the voltage over the whole or a part of the main current path,

wherein the device is arranged for control of the condition of stationary electrical contacts in electric power installations, wherein at least one current pulse has an amplitude equivalent to the rated current of the installation concerned,

the measuring and control unit is arranged to sample approximately corresponding values of the current and voltage at least in the area near the peak of the current progression and at a number of different current values,

the measuring and control unit comprises an input stage adapted to convert the sampled current and voltage measurements to digital time series or sequences, $i(n)$ and $u(n)$, respectively, where $1<n<N$ and where $N$ is the total number of samples in each time series,

and in that a microprocessor or computer is adapted for acquisition, filtering, storing and further processing of the time series,

and in that the resistance of the whole or a part of the main current path of the installation is calculated in the microprocessor or the computer.

It is a second purpose of the invention to provide a method and a device for control of the condition of electrical contacts in electrical power installations which also provides measurement data making it simple for an operator to establish whether one or more contacts in an $SF_6$ installation show signs of ageing.

It is a third purpose of the invention to provide a method and a device for the control of the condition of electrical contacts in electrical power installations which can make do with a more lightweight current supply than in previously known techniques.

It is a fourth purpose of the invention to provide a method and device for the control of the condition of electrical contacts in electrical power installations which rapidly and efficiently can provide accurate values for the resistance in a section of the main current path of the installation such that changes in the resistance at heavy loads easily may be found without opening the installation and without requiring knowledge of reference values.

The above purposes are achieved with a method which according to the present invention is characterised in that the method is arranged for control of the condition of stationary electrical contacts in electric power installations, wherein at least one current pulse has an amplitude equivalent to the rated current of the installation concerned, and

that approximately corresponding values of the current and voltage are sampled (20A,20B) at least in the area near the peak of the current progression and at a number of different current values, in order to form time series or sequences of samples, $i(n)$ and $u(n)$, respectively, where $1<n<N$ and where $N$ is the total number of samples in each time series, and the samples are transferred to a microprocessor or computer (50) for calculation of the resistance.

A device for achieving the above-mentioned purposes is according to the present invention according to the features of claims 11 to 14.

The invention will be explained in more detail in the following with reference to the accompanying drawings, where:

Figure 1 shows equipment for measuring according to the invention for the control of the condition of the contacts in $SF_6$-installations.

Figure 2 shows a simplified circuit diagram for the current supply, cable connections and the electric installation, for example an $SF_6$-installation.

Figure 3 shows a display of measurement samples for a complete measurement and the corresponding measurement samples after correction of supply noise and dc offset.

Figure 4 shows a display of the estimated impedance and resistance based on the measurements.

Figure 5 shows a sequence diagram for a measurement.

Figure 6 shows how the input stages for the data acquisition are put together.

Figure 7 shows the progression of the current and voltage as registered in an $SF_6$-installation.

Figure 8 shows current pulses which appear when a capacitor bank which has been charged to different voltages is discharged through an $SF_6$-installation.

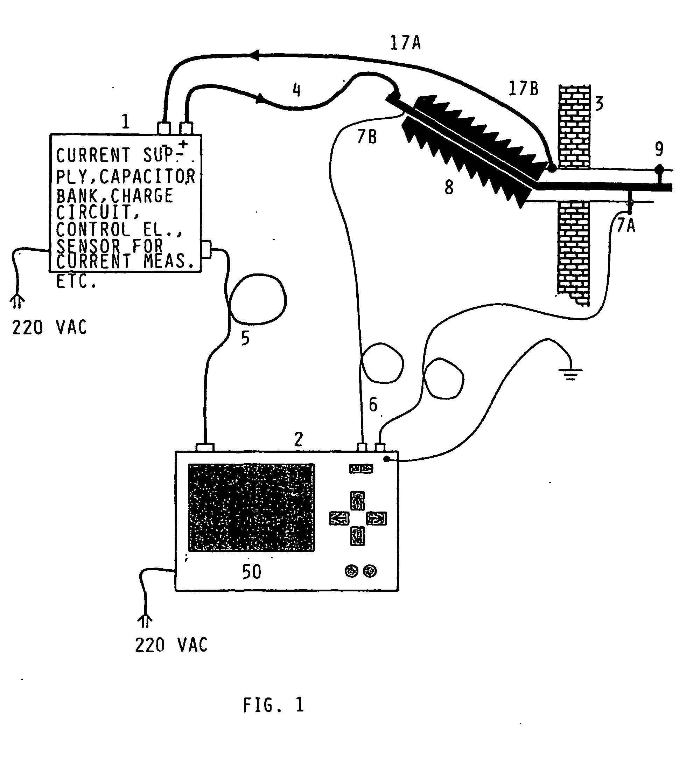

Figure 1 shows a current supply 1 taking its electrical energy from the mains supply (220 VAC). From a measuring-and control unit 2 the current supply 1 receives control signals via a signal cable 5. Using the signal cable 5 the current source 1 transfers an analogue signal from an internal current sensor back to the measuring and control unit 2. The current supply 1 is coupled to the electric installation 3 to be tested via connection cables 4-which are coupled to an aerial line feed through 8 on the electrical installation.

The connecting cables 4 can lead the current to the electric installation 3 by the connection to an aerial line feed through 8, through an isolated earth connection, or at some other available place (Fig. 1, 17A, 17B). The current is then sent through the section of the installation to be checked and into the encapsulation through an earth connection 9, and subsequently back through the encapsulation to the starting point. The connecting cables 4 should be placed between the current supply 1 and the electric installation 3 in such a way that the inductance which they form remains as low as possible. In practice this means that the connecting cables should not form a larger area or a larger loop than necessary - they should advantageously be twisted, as far as this is possible.

Measuring cables 6 for the voltage measurement are connected in a way similar to conventional four-point resistance measurements. This means that the measuring cables should be coupled between the coupling points (17A,17B) such that the resistance in the connection between the connecting cables 4 and the installation 3 is not included. Measuring cables 6 have to be connected in such a way that the voltage drop in the encapsulation is not included. The measuring and control unit 2 is connected via measuring cables 6 to the installation 3 such that one of the measuring cables 6 is connected with the feed through 8 of the installation 3 while the other measuring cable 6 is connected to the earth potensial of the electrical installation using an isolated earth connection 7.

Regarding the measuring cables 6 it is an advantage to avoid large loops. In particular if there are aerial cables in the proximity with a high current load and hence a strong magnetic field, it could be induced an amount of noise around the frequency of the electrical mains supply and its harmonics if the measuring cables are arranged in an unfavourable manner. If the conditions are suited for this, the best is to twist the cable around the encapsulation of the section to be investigated.

Control signals from the measuring and control unit 2 decides the time of a current discharge from the current supply 1. The control signals further decide when the current source is to charge the capacitors after a current discharge.

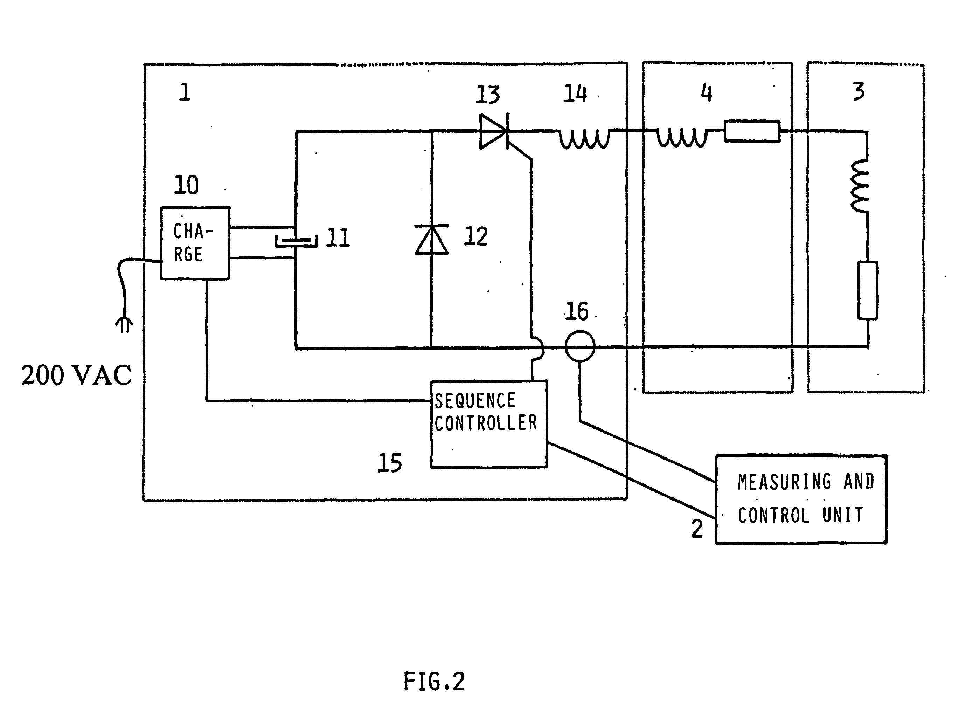

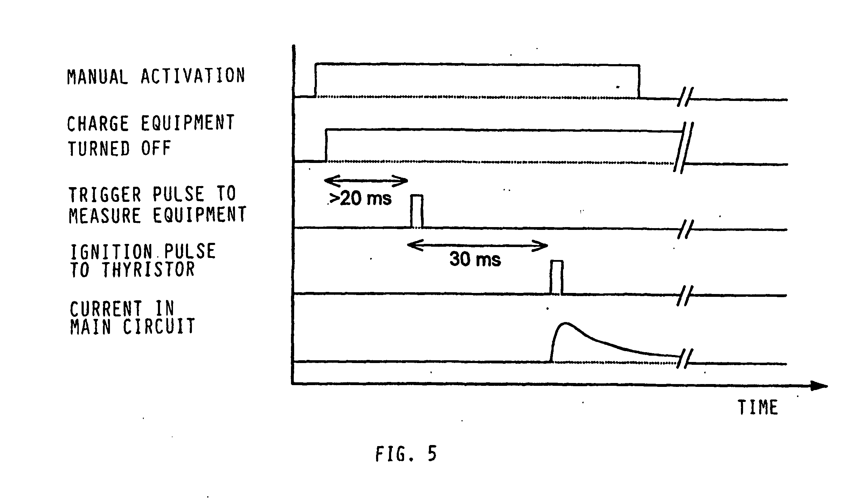

Figure 2 shows the current supply in more detail and Figure 5 shows a typical sequence diagram for a measurement sequence. The current supply 1 contains one or more capacitors 11, which are charged from the mains supply using a rectifier 10. The capacitors have a typical capacitance of 4 Farad. A typical charging voltage is a few tens of volts. The capacitors are coupled via a thyristor 13 and an air coil 14 to the electric installation 3 to be checked, i.e. an $SF_6$-installation, using connecting cables 4. The resistance and inductance of the connecting cables are indicated using symbols in Figure 2.

The measuring and control unit 2 may be equipped with a "Start"-button such that an operator may start a measurement manually. Upon the operator's activation of the "start"-button the measuring and control unit 2 sends an activation signal to a sequence controller 15 which may be a part of the current supply 1 and which controls the further sequence of the current pulses. The sequence controller 15 controls the discharging and charging of the current supply 1.

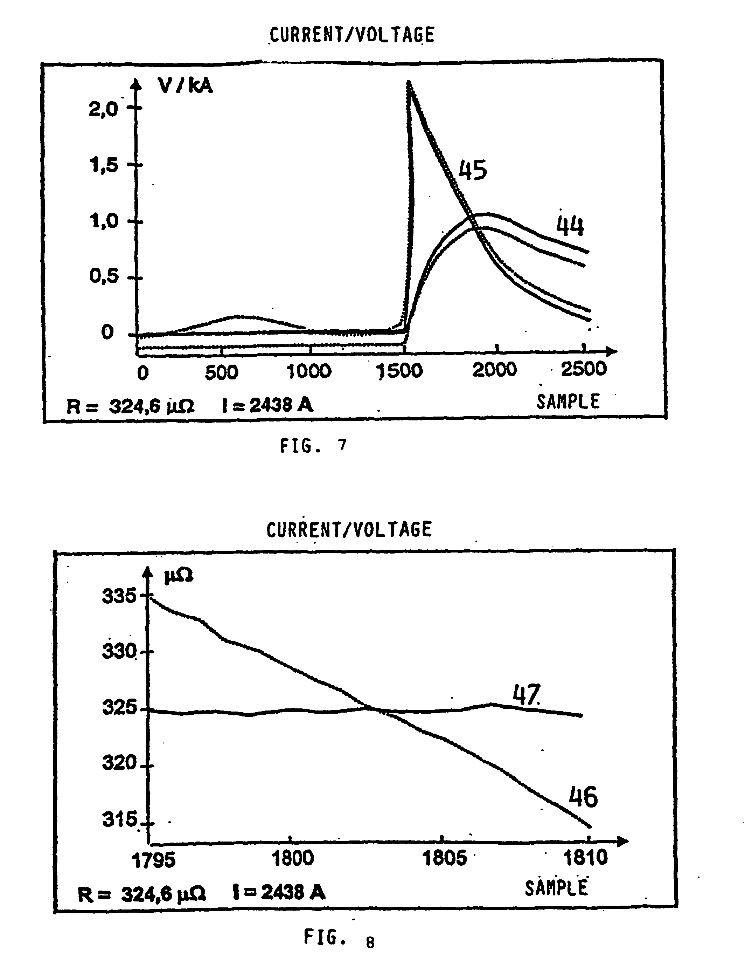

A typical sequence as illustrated in Figure 5 will be that the sequence controller 15 sends out a disconnection signal 37 to the charging circuit 10 for a few seconds. Some milliseconds, e.g. 20 ms, after the deactivation of the charging circuit, a trigging pulse 38 is sent to the analogoue-to-digital converters 20 of the measurement and control unit 2 such that measurement of approximately corresponding values of current and voltage is initiated. The sequence controller 15 then transmits an igniting pulse 39 to the thyristor 13 which is ignited and is used as a coupling element. The electrical energy which is stored in the capacitors is then discharged through the circuit to be checked in the form of a current pulse 40. The form of the current pulse is determined by the circuit parameters, but normally changes very little from current pulse to current pulse. Typically, the rise time will be very short, in the range of a few milliseconds, i.e. in the same range as for example a quarter of a period of the mains signal, and after a peak value has been reached an exponentially decaying progression follows, see also Figure7. The amplitude of the current pulse can reach for example 3000-5000 Ampere at fully charged capacitors. When the current pulse has its maximum value 30, the capacitor voltage is approximately equal to the resistive voltage drop in the circuit. When the current starts to decay, the inductances of the circuit will try to maintain the current. A free-wheeling diode 12 prevents damage to the capacitors 11 from charging in the reverse direction. The free-wheeling diode will also prevent oscillations in the circuit and ensure that the current pulse decays more slowly after the peak. Capacitors 11 discharges completely or almost completely each time they deliver a current pulse.

After each current pulse the sequence controller 15 terminates the disconnection signal 37 to the charging circuit 10 such that a new charging may start. Capacitors are then charged to the required voltage.

Integrated in the current supply 1 there is an air coil 14 in order to reduce the short circuit current in the case of unwanted short circuiting of the terminations and to avoid damage to the thyristor 13. In addition, the air coil also affects the progression of the current pulse positively in that it contributes to a slower decay of the current pulse after the peak.

The current supply 1 also comprises a current sensor 16 comprising a Rogowski coil with an integrator for accurate measurement of the current. The current sensor 16 provides a voltage signal which at any time is proportional to the current.

The connecting cables 4 which connects the current supply 1 with the circuit to be examined, must have a relatively large cross sectional area in order that the voltage drop does not become too large and should for the same reason not be longer than necessary. They may, for example, be 70 mm$^2$ flexible, rubber isolated

copper cables, so-called "welding cable". In practice the current supply should be placed as close to the coupling points 17A,17B of the electrical installation as possible. Usually it is convenient to use the encapsulation as a return conductor, and to connect the cables to live and earth connections of a feed through 3 as shown in Figure 1. For the largest installations it is convenient to arrange the current supply 1 in a lifting elevator or the like, depending on the local conditions. All the functions of the current supply 1 are controlled from the measuring and control unit 2, such that a somewhat difficult to access location of the current supply 1 for this reason is not particularly problematic.

The measurement and control unit 2 contains analogue-to-digital (A/D) converters 20 which have a differential channel 20A for current measurement and one for voltage measurement 20B. In order to achieve sufficient accuracy in the measurements the A/D-converters should have 16 bit resolution and a deviation from linearity of less than 0.5% within a measuring range of -5 to +5 Volt. They also must be able to handle a sampling frequency of 50 kHz. The component Transguard S14K17 could for example be used.

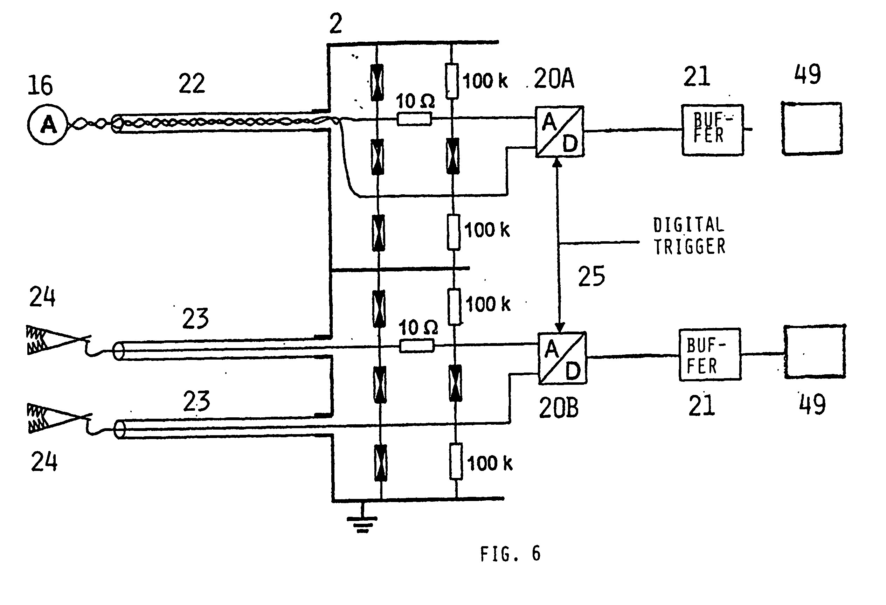

Figure 6 shows in detail the input stage 26 in the measurement and control unit for transformation of the analogue voltages from the Rogowski coil and from the potential difference from the electrical installation, respectively, to digital time sequences.

Both signals will typically have an amplitude of up to a few volts, and only to a small extent contain frequency components higher than a few hundred hertz. The A/D converters are activated by applying the triggering signal 38 (fig. 5) to the triggering input 25 of the A/D converters.

For the voltage measurement an ordinary coaxial cable 23 can be used where the centre conductor ends in a large crocodile clip 24 which can be connected to the electrical installation. The screen is earthed via the chassis of the measuring and control unit and can be led all the way to, but not connected at the measuring point in the installation. The cables are connected to the measuring and control unit at the installation using bayonet connections or the like.

For the current measurement the signal is transferred from the Rogowski coil 16 through a twisted two-wire 22 with a screen which is integrated in the cable between the current supply 1 and the measuring and control unit 2.

Following A/D conversion the digital data are stored in buffers 21 which can store a full measuring period, for example 2500 samples corresponding to a measuring sequence of 50 ms length. From the buffers the measuring data are further transferred for digital filtering, other additional processing and calculation.

The measuring and control unit 2 filters the measuring values, estimates and subtracts the inductive voltage drop, and thereafter determines the resistance of the circuit for the time when the current has its maximum value.

Figure 7 shows a more detailed image of a typical progression of the current and voltage as registered in an $SF_6$-installation. The voltage has an exponentially falling progression. The current has a rapidly rising flank 31, then reaches a peak or maximum value 30. Then the current has a falling exponential progression 32. The analogue measurement values are being sampled in the measuring and control unit.

The current progression is sampled at least near the top of the current progression 30. The samples form time sequences $i(n)$. An approximately corresponding time sequence, $u(n)$, is sampled for the voltage progression. A computer or microprocessor 50 (Fig. 1), which normally will be an integrated part of the measuring and control unit 2, performs the further processing of the samples.

In one embodiment the application of electric current from the current supply 1 is performed in the form of one single current pulse while the current and voltage progressions are sampled a plurality of times during the falling flank thereby forming time sequences $i(n)$ and $u(n)$. Hence, the current progression $i(n)$ will take on a number of different values. In this single-pulse version the current supply is preferably charged to a voltage which is high enough for the resulting peak value 30 of the current pulse to be close to the maximum rated current of the installation. The rated current of the installation is another known term for the maximum load current of the installation.

In another embodiment the application of electrical energy from the current supply 1 in the form of a plurality of current pulses of varying current. Figure 8 illustrates the progression of the current for such a set of current pulses 40A-C which result when the capacitor bank is charged to different voltages before being discharged. At least one of the current pulses has a peak value which is close to the rated current of the installation.

The further processing of the time sequences $i(n)$ and $u(n)$ is aimed at obtaining the resistance of the circuit at different current values. For the single-pulse embodiment the resistance is estimated at the different current values along the falling flank of the current pulse. For the multi-pulse embodiment the resistance is estimated at the peak of the current pulse for each single current pulse. As the current pulses have varying peak values for the current a set of resistance values is formed for varying current values.

The calculations have to take into account several aspects. Firstly, the current and voltage measurements may contain both high frequency noise (from radio transmitters, discharges, etc) and mains frequency noise (e.g. 16 2/3 Hz, 50 Hz, or 60 Hz). Secondly, the circuit impedance contains an inductive component which has to be subtracted in order to arrive at the resistance.

All frequency components above a few hundred Hz are regarded as noise. These are removed using a steep digital filter 49. A bandstop FIR (Finite Impulse Response) filter with break-off frequency of 250 Hz and an attenuation of 44 dB has been tested and found to work well.

Noise at the mains frequency and dc offset from A/D converters is subsequently removed assuming that this noise is predictable. The following procedure can be used:

1) The sequence controller 15 is set such that the data acquisition starts about 30 ms or 1500 samples before the current pulse starts. The interval hence normally contains only low frequency noise as well as dc voltage offset from the A/D converters.

2) A section exactly one mains period long is extracted from sample no. 250 to sample no. 1249 of each channel (provided 50 kHz sampling frequency),

3) The extracted sections are copied two or three times and the sections are laid one after the other to form a 2500 sample long time sequence for each channel. These time sequences are being used as a measure of low frequency noise and dc voltage offset.

4) The noise time sequences are subtracted from the time sequences for both channels.

5) The result in the form of a 2500 element long time sequence for each channel is stored and used in subsequent processing. The time sequences are denoted $i(n)$ and $u(n)$ where $1<n<2500$ for the current and voltage signal respectively. The dimensions are [kA] and [V], respectively.

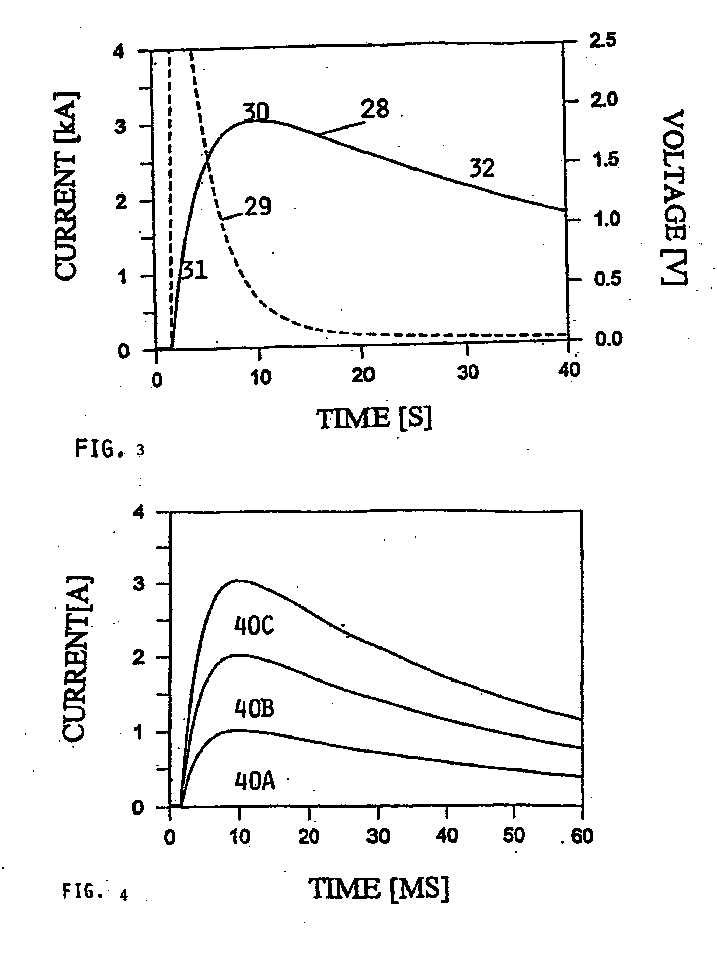

Figure 3 shows an image of the time sequences $i(n)$ for current 44 and $u(n)$ for voltage 45 both prior to and after filtering of mains noise and correction of dc voltage offset. In Figure 3 a dotted line shows the measuring samples and the solid line shows the corrected data. The curve section in Figure 3 shows all 2500 measuring samples for a typical measurement progression.

At the mains frequency there is a voltage drop over a section of the $SF_6$ installation, mainly inductively induced, typically X/R=3, where X is the reactance and R is the resistance.

When a current pulse is sent through, the resistive voltage drop constitutes a varying part of the total, measured voltage drop. The resistive part is lowest at the rising flank of the current pulse as $di/dt$ here is at its largest, and it is largest as the current pulse reaches its peak value 30. Then $di/dt=0$ and the inductive part of the voltage drop is therefore zero as well.

The resistance of the circuit is not constant either, as the penetration depth of the current increases through a current progression. The resistance is hence somewhat higher at the rising edge 31 of the current pulse than on the falling edge 32.

The challenge is essentially to estimate the purely resistive contribution to the impedance in such a way that minor deviance can be found when the results from several pulses of different peak value of the current are compared.

In one embodiment the inductance, L, of the circuit is first determined by regression, and from this the reactance is found through a part of the pulse progression. The reactance is then subtracted from the measured impedance, such that the purely resistive contribution remains. The resistive contribution at the peak value of the current is taken as the resistance of the circuit.

In more detail the resistance may be determined by processing the two time sequences $i(n)$ and $u(n)$ for $1<n<2500$ in the following manner;

1) The time where the current has its peak value is determined by finding the n at which the time sequence $i(n)$ has its largest value. This is denoted $n_{max}$.

2) One segment of 200 samples is extracted from the current measurements $i(n)$ and the voltage measurements $u(n)$ around the time at which the current has its peak value, i.e. for $n_{max-99}<n<n_{max+100}$.

3) A new time series $didt(n)$ which is the derivative of the 200 points long segment of the current signal is determined. This is performed by calculation of $didt(n) = [i(n+1)-i(n)] / 20$ for $n_{max-99}<n<n_{max+99}$. This series of 199 samples has the dimension [MA/s]

4) A new time series $didt\_over\_i(n) = didt(n) / i(n)$ is determined for $n_{max-99}<n<n_{max+99}$. This series gets the dimension [1/ms].

5) A new series $z(n) = u(n) / i(n)$ for $n_{max-99}<n<n_{max+99}$ is determined. The dimension of z(n) becomes [mΩ].

6) A linear curve fit using e.g. a least squares method is performed to determine the coefficient L in the expression $z(n) = R + L\ didt\_over\_i(n)$ for $n_{max-99}<n<n_{max+99}$. The dimension of the coefficient L becomes [μH].

7) A new time series $r(n) = z(n) - L\ didt\_over\_i(n)$ is calculated for $n_{max-99}<n<n_{max+99}$.

8) The resistance at the peak value of current $r(n_{max})$ is read.

Figure 4 shows an image of the time series 46,47 for the calculated impedance z(n) and resistance r(n) for a segment of the test progression close to the time of the peak value of the current 30. In this segment the resistance curve 47 is approximately a flat curve. Possible deviations from a flat, horizontal curve may be calculated and used to form a target for the statistical uncertainty of the measurement.

A microprocessor based system is used both to implement the above mentioned routines and to construct a user interface (presentation in display images).

As an example curves may show the progression of the test itself and the calculated time sequences as shown in Figure 3 and 4. In the same images of the progression of the test the most important results of the test may also be shown, i.e. the peak value of the current and the corresponding calculated resistance. In this way the user has the possibility of evaluating how well the tests are. Possible serious faults in the progression of the tests may in this way simply be identified. Further, the most important data of the sequence control is also shown.

The microprocessor based system preferably also contains conventional functions for storing several test progressions, displaying previous test progressions and functions for transferring measurement data to a PC.

## Claims

1. Method for control of the condition of electrical contacts in electric power installations, particularly in installations having one or more contacts and where the whole or parts of the main current path is encapsulated or in other ways difficult to reach, such as in gas isolated connection installations, comprising applying electric current (28) from a current supply (1) which is connected to the main current path of said electric power installation (3), measuring (16) of the progression of the applied current, measuring (2) a resulting electric voltage appearing over a particular part of the main current path, and estimating the resistance of said part on the basis of the measurements of current and voltage as an expression of the condition of the contacts, **characterised in that** electric current from discharge of at least one capacitor (11) which is part of the current supply (1) is such that at least one unipolar current pulse (28) is formed, having an initial rising flank (31) which is significantly steeper than the falling end flank (32) of the current pulse, and the current pulse has a maximum amplitude or peak (30) in an area between the flanks, the method being arranged for control the condition of stationary electrical contacts in electric power installations, wherein at least one current pulse has an amplitude equivalent to the rated current of the installation concerned, and that approximately corresponding values of the current and voltage are sampled (20A,20B) at least in the area near the peak of the current progression and at a number of different current values, in order to form time series or sequences of samples, i(n) and u(n), respectively, where 1<n<N and where N is the total number of samples in each time series, and the samples are transferred to a microprocessor or computer (50) for calculation of the resistance.

2. Method according to claim 1, **characterised in that** the application of electric current from the current supply is made in a single pulse (28) and that the progressions of the current and voltage are sampled a plurality, N, times during the falling flank of the current pulse (32) thereby forming time sequences *i(n)* and *u(n)*.

3. Method according to claim 1, **characterised in that** the application of electric current from the current source is made in the form of a plurality of pulses (40A, 40B, 40C) of varying current amplitudes and that the current and voltage progressions are sampled at least once for each pulse, in the area near the top of the current progression, thereby forming time series *i(n)* and *u(n)*.

4. Method according to claim 2 or 3, **characterised in that** the current pulse(s) has a rise time of amplitude corresponding to the mains frequency.

5. Method according to claim 3, **characterised in that** the form of the current pulses are essentially similar.

6. Method according to claim 2 or 3, **characterised in that** the progressions of the current and voltage are sampled at moments near the peak value of the current and until the current has dropped significantly from this, to for example about 1/3 of its peak value.

7. Method according to one of the claims 1-6 **characterised in that** the calculation of the resistance comprises one or more of the following steps; removing dc-current offset, filtering high frequency noise, filtering mains frequency noise and correction for inductive voltage drop.

8. Method according to claim 7, **characterised in that** the correction of inductive voltage drop comprises the following steps; identifying the sample where the progression of current has its peak value, extracting a number of samples from the current and voltage measurements around the time of the peak value of the current, estimating the inductance, L, using linear curve fitting of

$$\frac{u(n)}{i(n)} = R + L\frac{[i(n)-i(n-1)]/\Delta T}{i(n)}$$

where $\Delta T$ is the sampling interval, and calculating a new time series where the inductive contribution to the voltage drop is substracted, such that the result is the resistance, *r(n)*, which is required to be determined.

9. Method according to claim 7,
**characterised in that** the filtering of high-frequency noise is performed by filtering of the signals in a digital low pass filter (49).

10. Method according to claim 7,
**characterised in that** the filtering of mains frequency noise and dc-voltage offset comprises the steps; forming a time series representing the mains frequency noise and dc-voltage offset by extracting a number of samples corresponding to one or a number of mains periods prior to applying the current pulse from the time series for forming a segment,
copying said segment a number of times and laying these copies one after the other to form two longer time series, one voltage noise time series and one current noise time series,
and subtracting said noise time series from the registered current and voltage progressions.

11. Device for the control of the condition of electrical contacts of electric power installations, particularly in installations where the whole or parts of the main current path is encapsulated or in other ways difficult to reach, such as in gas isolated connection installations comprising a current supply (1) which is adapted to be connected to the main current path in an electric power installation (3),
**characterised in that** the device comprises one or more capacitors (11) for supplying at least one current pulse (28) having an initial rising flank (31) being significantly steeper than the rear falling flank (32) of the current pulse where the current pulse has a peak value (30) in a range between the flanks,
means for current measurement (16),
a measuring and control unit (2) which is adapted to be connected to the current supply for supplying a control signal and for the receiving of measured current values from said means for current measurement, and
the measuring and control unit (2) is adapted to measure the voltage over the whole or a part of the main current path,
wherein the device is arranged for control of the condition of stationary electrical contacts in electric power installations, wherein at least one current pulse has an amplitude equivalent to the rated current of the installation concerned,
the measuring and control unit (2) is arranged to sample approximately corresponding values of the current and voltage (20A,20B) at least in the area near the peak of the current progression and at a number of different current values,
the measuring and control unit (2) comprises an input stage (26) adapted to convert the sampled current and voltage measurements to digital time series or sequences, *i(n)* and *u(n)*, respectively, where $1 < n < N$ and where N is the total number of samples in each time series,
that a microprocessor or computer (50) is adapted for acquisition, filtering, storing and further processing of the time series,
and that the resistance of the whole or a part of the main current path of the installation is calculated in the microprocessor or the computer.

12. Device according to Claim 11,
**characterised in that** the current supply is adapted to supply one single current pulse and that the measuring and control unit comprises arrangements to sample the progression of the current and voltage several times during the falling flank of this single pulse thereby providing time series *i(n)* and *u(n)* where the values vary during the course of the falling flank of the current pulse.

13. Device according to claim 11,
**characterised in that** the current supply is adapted to supply a plurality of pulses of varying current amplitudes,
and that the measuring and control unit comprises arrangements to sample the current and voltage at least once during each pulse, preferably near the peak of the current pulse.

14. Device according to one of the claims 11-13,
**characterised in that** the current supply comprises one or more of the following elements:

a free-wheeling diode (12) connected in parallel over the capacitors of the current supply,

an air coil (14) connected in series at the output of the current supply and a current sensor comprising a Rogowski coil (16) having an integrator adapted to sense the current from the current supply.

**Patentansprüche**

1. Verfahren zur Kontrolle des Zustands elektrischer Kontakte in elektrischen Stromversorgungsinstallationen, insbesondere in Installationen, die einen oder mehrere Kontakte aufweisen und wo der gesamte Hauptstromweg oder Teile desselben eingekapselt sind oder auf andere Weise schwierig zu erreichen sind, wie z. B. in gasisolierten Verbindungsinstallationen,
das es aufweist, elektrischen Strom (28) von einer Stromquelle (1) anzulegen, die mit dem Hauptstromweg der elektrischen Stromversorgungsinstallation (3) verbunden ist,

den Verlauf des angelegten Stroms zu messen (16),

eine resultierende elektrische Spannung zu messen (2), die über einem besonderen Teil des Hauptstromwegs erscheint,

und den Widerstand dieses Teils aufgrund der Messungen von Strom und Spannung als einen Ausdruck des Zustands der Kontakte zu schätzen, **dadurch gekennzeichnet, dass** elektrischer Strom von Entladung von dem wenigstens einen Kondensator (11), der Teil der Stromquelle (1) ist, so ist, dass wenigstens ein unipolarer Strompuls (28) gebildet wird, der eine anfängliche Anstiegsflanke (31) aufweist, die beträchtlich steiler ist als die abfallende Endflanke (32) des Strompulses, und dass der Strompuls eine maximale Amplitude oder einen Spitzenwert (30) in einem Bereich zwischen den Flanken hat,

wobei das Verfahren für Kontrolle des Zustands stationärer elektrischer Kontakte in elektrischen Stromversorgungsinstallationen ausgebildet ist, wobei wenigstens ein Strompuls eine Amplitude hat, die dem Nennstrom der betreffenden Installation äquivalent ist, und

dass ungefähr entsprechende Werte des Stroms und der Spannung wenigstens im Bereich nahe dem Spitzenwert des Stromverlaufs und an einer Anzahl unterschiedlicher Stromwerte abgetastet werden (20A, 20B), um Zeitreihen oder Sequenzen von Abtastwerten i(n) und u(n) zu bilden, wobei 1<n<N und N die Gesamtanzahl von Abtastwerten in jeder Zeitreihe ist, und dass die Abtastwerte zu einem Mikroprozessor oder Computer (50) zum Berechnen des Widerstandes übertragen werden.

2. Verfahren nach Anspruch 1, **dadurch gekennzeichnet, dass** die Anlegung des elektrischen Stroms von der Stromquelle in einem einzigen Puls (28) durchgeführt wird, und dass die Verläufe von Strom und Spannung durch eine Mehrzahl N von Malen während der abfallenden Flanke des Strompulses (32) abgetastet werden, wodurch Zeitsequenzen i(n) und u(n) gebildet werden.

3. Verfahren nach Anspruch 1, **dadurch gekennzeichnet, dass** die Anlegung von elektrischem Strom von der Stromquelle in der Form einer Mehrzahl von Pulsen (40A, 40B, 40C) mit variierenden Stromamplituden durchgeführt wird und dass die Strom- und Spannungsverläufe wenigstens einmal für jeden Puls in einem Bereich in der Nähe des höchsten Wertes des Stromverlaufs abgetastet werden, wodurch Zeitserien i(n) und u(n) gebildet werden.

4. Verfahren nach Anspruch 2 oder 3, **dadurch gekennzeichnet, dass** der Strompulse/die Strompulse eine Anstiegszeit der Amplitude hat/haben, die der Netzfrequenz entsprechen.

5. Verfahren nach Anspruch 3, **dadurch gekennzeichnet, dass** die Formen der Strompulse im Wesentlichen ähnlich sind.

6. Verfahren nach Anspruch 2 oder 3, **dadurch gekennzeichnet, dass** die Verläufe von Strom und Spannung bei Momenten nahe dem Spitzenwert des Stroms und bis der Strom beträchtlich von diesem Wert abgefallen ist, auf z. B. ungefähr ein Drittel des Spitzenwertes, abgetastet werden.

7. Verfahren nach einem der Ansprüche 1 bis 6, **dadurch gekennzeichnet, dass** die Berechnung des Widerstandswertes einen oder mehrere der folgenden Schritte aufweist:

> Gleichstromversetzung oder -verschiebung zu entfernen,
>
> Hochfrequenzrauschen zu filtern,
>
> Netzfrequenzrauschen zu filtern, und
>
> Korrektur für induktiven Spannungsabfall.

8. Verfahren nach Anspruch 7, **dadurch gekennzeichnet, dass** die Korrektur des induktiven Spannungsabfalls die folgenden Schritte aufweist:

> den Abtastwert zu identifizieren, wo der Stromverlauf seinen Spitzenwert hat,
>
> eine Anzahl von Abtastwerten von Strom- und Spannungsmessungen um die Zeit des Spitzeswertes des Stromes herum zu extrahieren,
>
> die Induktivität L unter Verwendung der linearen Kurvenanpassung
>
> $$\frac{u(n)}{i(n)} = R + L\frac{[i(n)\text{-}i(n\text{-}1)]/\Delta T}{i(n)}$$
>
> zu schätzen, wobei $\Delta T$ das Abtastintervall ist,
>
> und eine neue Zeitreihe zu berechnen, wo der induktive Beitrag zum Spannungsabfall abgezogen ist, so dass das Ergebnis der Widerstandswert r(n) ist, der bestimmt werden soll.

9. Verfahren nach Anspruch 7, **dadurch gekennzeichnet, dass** das Filtern von Hochfrequenzrauschen durch Filtern der Signale in einem digitalen Tiefpassfilter (49) durchgeführt wird.

10. Verfahren nach Anspruch 7, **dadurch gekennzeichnet, dass** das Filtern des Netzspannungsrauschens und der Gleichspannungsversetzung die Schritte aufweist:

eine Zeitreihe zu bilden, die das Netzfrequenzrauschen und die Gleichspannungsversetzung darstellt, indem eine Anzahl von Abtastwerten extrahiert wird, die einer Netzperiode oder einer Anzahl von Netzperioden vor Anlegen des Strompulses von den Zeitreihen zum Bilden eines Segmentes entsprechen;

das Segment eine Anzahl von Malen zu kopieren und diese Kopien eine nach der anderen abzulegen, um zwei längere Zeitreihen zu bilden, eine Spannungsrauschenzeitserie und eine Stromrauschenzeitserie, und

die Rauschenzeitserien von den registrierten Strom- und Spannungsverläufen zu subtrahieren.

11. Vorrichtung zum Kontrollieren des Zustands von elektrischen Kontakten von elektrischen Stromversorgungsinstallationen, insbesondere in Installationen, wo der gesamte Hauptstromweg oder Teile desselben eingekapselt oder auf andere Weise schwierig zu erreichen sind, wie z. B. in gasisolierten Verbindungsinstallationen, die eine Stromquelle (1) aufweist, die dazu ausgebildet ist, zum Hauptstromweg in einer elektrischen Stromversorgungsinstallation (3) verbunden zu werden, **dadurch gekennzeichnet, dass** die Vorrichtung einen oder mehrere Kondensatoren (11) zum Zuführen von wenigstens einem Strompuls (28), der eine anfängliche Anstiegsflanke (31) aufweist, die beträchtlich steiler ist als die hintere abfallende Flanke (32) des Strompulses ist, wobei der Strompuls einen Spitzenwert (30) im Bereich zwischen den Flanken aufweist,
Mittel für Strommessung (16),
eine Mess- und Kontrolleinheit (2), die dazu ausgebildet ist, mit der Stromversorgung verbunden zu werden, um ein Kontrollsignal zu liefern und um gemessene Stromwerte von den Mitteln für Strommessung zu empfangen, aufweist und
wobei die Mess- und Steuereinheit (2) dazu ausgebildet ist, die Spannung über den gesamten Hauptstromweg oder einen Teil desselben zu messen,
wobei die Vorrichtung zur Kontrolle des Zustands von stationären elektrischen Kontakten in elektrischen Stromversorgungsinstallationen ausgebildet ist, wobei wenigstens ein Strompuls eine Amplitude hat, die dem Nennstrom der betreffenden Installation äquivalent ist,
wobei die Mess- und Kontrolleinheit (2) dazu ausgebildet ist, ungefähr entsprechende Werte des Stroms und der Spannung (20A, 20B) wenigstens im Bereich nahe dem Spitzenwert des Stromverlaufs und an einer Anzahl von unterschiedlichen Stromwerten abzutasten,
wobei die Mess- und Steuereinheit (2) eine Eingangsstufe (26) aufweist, die dazu ausgebildet ist, die abgetasteten Strom- und Spannungsmessungen in digitale Zeitserien oder Sequenzen i(n) und u(n) umzuwandeln, wobei 1<n<N die gesamte Anzahl von Abtastwerten in jeder Zeitserie ist,
dass ein Mikroprozessor oder Computer (50) für Aufnehmen, Filtern, Speichern und weiteres Bearbeiten der Zeitserien ausgebildet ist;
und dass der Widerstandswert des gesamten Hauptstromwegs der Installation oder ein Teil desselben in dem Mikroprozessor oder Computer berechnet wird.

12. Vorrichtung nach Anspruch 11, **dadurch gekennzeichnet, dass** die Stromversorgung dazu ausgebildet ist, einen einzigen Strompuls zu liefern, und dass die Mess- und Steuereinheit Anordnungen aufweist, um den Verlauf des Stroms und der Spannung mehrere Male während der abfallenden Flanke dieses einfachen Pulses abzutasten, wodurch Zeitserien i(n) und u(n) geliefert werden, wobei sich die Werte während des Verlaufs der abfallenden Flanke des Strompulses verändern.

13. Vorrichtung nach Anspruch 11, **dadurch gekennzeichnet, dass** die Stromversorgung dazu ausgebildet ist, eine Mehrzahl von Pulsen von unterschiedlichen Stromamplituden zu liefern, und dass die Mess- und Kontrolleinheit Anordnungen zum Abtasten des Stroms und der Spannung wenigstens einmal während jedes Pulses, vorzugsweise nahe dem Spitzenwert des Strompulses aufweist.

14. Vorrichtung nach einem der Ansprüche 11 bis 13, **dadurch gekennzeichnet, dass** die Stromversorgung eines oder mehrere der folgenden Elemente aufweist:

eine Freilaufdiode (12), die parallel über die Kondensatoren der Stromquelle verbunden ist,

eine Luftspule 14, die in Reihe am Ausgang der Stromversorgung verbunden ist, und einen Stromsensor, der eine Rogowski-Spule (16) aufweist, der einen Integrator aufweist, der dazu ausgebildet ist, den Strom von der Stromversorgung zu detektieren.

## Revendications

1. Procédé pour commander la condition de contacts électriques dans des installations de courant électrique, notamment dans des installations possédant un ou plusieurs contacts et où l'intégralité ou une partie du chemin de courant principal est encapsulée ou difficile à atteindre de quelque manière que ce soit, comme dans les installations de connexion isolées de gaz,

comprenant l'application d'un courant électrique (28) depuis l'alimentation électrique (1) connectée au chemin de courant principal de ladite installation de courant électrique (3),

mesurant (16) la progression du courant appliqué,

mesurant (2) une tension électrique résultante apparaissant sur une partie spécifique du chemin de courant principal,

et estimant la résistance de ladite partie sur la base des mesures de courant et de tension comme une expression de la condition des contacts,

**caractérisé en ce que** le courant électrique issu de la décharge d'au moins un condensateur (11) faisant partie de l'alimentation électrique (1), est tel qu'est formée au moins une impulsion de courant unipolaire (28), ayant un front montant initial (31) qui est significativement plus abrupt que le front descendant final (32) de l'impulsion de courant, et l'impulsion de courant possède une amplitude ou pic maximal (30) dans une zone comprise entre les fronts,

le procédé étant agencé pour commander la condition des contacts électriques fixes dans des installations de courant électrique, dans lequel au moins une impulsion de courant possède une amplitude équivalente au courant nominal de l'installation concernée, et

les valeurs approximativement correspondantes du courant et de la tension sont échantillonnées (20A, 20B) au moins dans la zone proche du pic de la progression de courant et à un certain nombre de valeurs de courant différentes, afin de former des séries chronologiques ou des séquences d'échantillons, i(n) et u(n), respectivement, où $1 < n < N$ et où N représente le nombre total d'échantillons dans chaque série chronologique, et les échantillons sont transférés vers un microprocesseur ou un ordinateur (50) pour calculer la résistance.

**2.** Procédé selon la revendication 1,
**caractérisé en ce que** l'application d'un courant électrique provenant de l'alimentation électrique est réalisée en une seule impulsion (28) et que les progressions du courant et de tension sont échantillonnées une pluralité, N, de fois pendant le front descendant de l'impulsion de courant (32) formant ainsi des séquences chronologiques i(n) et u(n).

**3.** Procédé selon la revendication 1,
**caractérisé en ce que** l'application du courant électrique provenant de la source de courant est réalisée sous la forme d'une pluralité d'impulsions (40A, 40B, 40C) d'amplitudes de courant différentes et **en ce que** les progressions de courant et de tension sont échantillonnées au moins une fois pour chaque impulsion, dans la zone proche du haut de la progression de courant, formant ainsi des séries chronologiques i(n) et u(n).

**4.** Procédé selon la revendication 2 ou 3,
**caractérisé en ce que** les impulsions de courant possèdent un temps de montée d'amplitude correspondant à la fréquence de réseau.

**5.** Procédé selon la revendication 3,
**caractérisé en ce que** la forme des impulsions de courant est en grande partie similaire.

**6.** Procédé selon la revendication 2 ou 3,
**caractérisé en ce que** les progressions de courant et de tension sont échantillonnées à des moments proches de la valeur de pic du courant et jusqu'à ce que le courant ait chuté de manière significative à partir de celle-ci, par exemple jusqu'à environ 1/3 de sa valeur de pic.

**7.** Procédé selon l'une des revendications 1 à 6,
**caractérisé en ce que** le calcul de la résistance comprend une ou plusieurs des étapes suivantes :

supprimer le décalage du courant continu,
filtrer le bruit à haute fréquence,
filtrer le bruit sur la fréquence de réseau, et
corriger la chute de tension inductive.

**8.** Procédé selon la revendication 7,
**caractérisé en ce que** la correction de la chute de tension inductive comprend les étapes suivantes :

identifier l'échantillon où la progression du courant atteint sa valeur de pic,
extraire un certain nombre d'échantillons des mesures de courant et de tension autour du moment de la valeur de pic du courant,
estimer l'inductance L, en utilisant un ajustement de courbe linéaire de

$$\frac{u(n)}{i(n)} = R + L\frac{[i(n)-i(n-1)]/\Delta T}{i(n)}$$

où $\Delta T$ représente l'intervalle d'échantillonnage,

et calculer une nouvelle série chronologique où la contribution inductive à la chute de tension est soustraite, de sorte que le résultat soit la résistance, r(n), à déterminer.

9. Procédé selon la revendication 7,
   **caractérisé en ce que** le filtrage du bruit à haute fréquence est réalisé en filtrant les signaux dans un filtre passe-bas numérique (49).

10. Procédé selon la revendication 7,
    **caractérisé en ce que** le filtrage du bruit sur la fréquence de réseau et le décalage du courant continu comprennent les étapes de :

    formation d'une série chronologique représentant le bruit sur la fréquence de réseau et le décalage de courant continu en extrayant un certain nombre d'échantillons correspondant à l'une ou à un certain nombre de périodes du réseau avant d'appliquer l'impulsion de courant depuis la série chronologique pour former un segment,

    copie dudit segment un certain nombre de fois et dépôt de ces copies l'une après l'autre afin de former deux séries chronologiques plus longues, une série chronologique du bruit de tension et une série chronologique du bruit de courant,

    et soustraction de ladite série chronologique de bruit des progressions de tension et de courant enregistrées.

11. Procédé pour commander la condition des contacts électriques des installations de courant électrique, notamment dans des installations où l'intégralité ou une partie du chemin de courant principal est encapsulée ou difficile à atteindre, comme dans des installations de connexion isolées de gaz comprenant une alimentation électrique (1) adaptée pour être connectée au chemin de courant principal dans une installation de courant électrique (3),
    **caractérisé en ce que** le dispositif comprend un ou plusieurs condensateurs (11) pour délivrer au moins une impulsion de courant (28) possédant un front montant initial (31) significativement plus abrupte que le front descendant arrière (32) de l'impulsion de courant où l'impulsion de courant possède une valeur de pic (30) sur une plage comprise entre les fronts,

    un moyen pour mesurer le courant (16),

    une unité de mesure et de commande (2) qui est adaptée pour être connectée à l'alimentation électrique afin de délivrer un signal de commande et pour la réception des valeurs de courant mesurées depuis ledit moyen de mesure de courant, et

    l'unité de mesure et de commande (2) est adaptée pour mesurer la tension sur l'intégralité ou une partie du chemin de courant principal,

    dans lequel le dispositif est agencé pour commander la condition des contacts électriques fixes dans des installations de courant électrique, dans lequel au moins une impulsion de courant possède une amplitude équivalente au courant nominal de l'installation concernée,

    l'unité de mesure et de commande (2) est agencée pour échantillonner des valeurs approximativement correspondantes du courant et de la tension (20A, 20B) au moins dans la zone proche du pic de la progression de courant et à un certain nombre de valeurs de courant différentes,

    l'unité de commande et de mesure (2) comprend un étage d'entrée (26) adapté pour convertir les mesures de courant et de tension échantillonnées en séries ou séquences chronologiques numériques, i(n) et u(n), respectivement, où $1<n<N$ et où N est le nombre total d'échantillons dans chaque série chronologique,

    un microprocesseur ou ordinateur (50) est adapté pour acquérir, filtrer, stocker et traiter en outre les séries chronologiques,

    et la résistance de l'intégralité ou d'une partie du chemin de courant principal de l'installation est calculée dans le microprocesseur ou l'ordinateur.

12. Dispositif selon la revendication 11,
    **caractérisé en ce que** l'alimentation électrique est adaptée pour délivrer une seule impulsion de courant et l'unité de commande et de mesure comprend des agencements pour échantillonner la progression du courant et de la tension plusieurs fois pendant le front descendant de cette seule impulsion en fournissant ainsi des séries chronologiques i(n) et u(n) où les valeurs varient pendant l'évolution du front descendant de l'impulsion de courant.

13. Dispositif selon la revendication 11,
    **caractérisé en ce que** l'alimentation électrique est adaptée pour délivrer une pluralité d'impulsions d'amplitudes de courant différentes,
    et **en ce que** l'unité de mesure et de commande comprend des agencements pour échantillonner le courant et la tension au moins une fois pendant chaque impulsion, de préférence près du pic de l'impulsion de courant.

14. Dispositif selon l'une des revendications 11 à 13,
    **caractérisé en ce que** l'alimentation électrique comprend un ou plusieurs des éléments suivants :

    une diode libre (12) connectée en parallèle sur les condensateurs de l'alimentation électrique, une bobine à air (14) connectée en série au niveau de la sortie de l'alimentation électrique et un capteur de courant comprenant une bobine de Rogowski (16) possédant un intégrateur adapté pour détecter le courant provenant de l'alimentation électrique.

17A
17B
3
9
1
7B
8
7A
CURRENT SUP-
PLY,CAPACITOR
BANK,CHARGE
CIRCUIT,
CONTROL EL.,
SENSOR FOR
CURRENT MEAS.
ETC.
220 VAC
5
6
2
50
220 VAC
4

FIG. 1

14

FIG.2

EP 1 388 015 B1

FIG. 3

FIG. 4

MANUAL ACTIVATION

CHARGE EQUIPMENT
TURNED OFF

TRIGGER PULSE TO
MEASURE EQUIPMENT

>20 ms

IGNITION PULSE
TO THYRISTOR

30 ms

CURRENT IN
MAIN CIRCUIT

TIME

FIG. 5

EP 1 388 015 B1

FIG. 6

CURRENT/VOLTAGE

FIG. 7

CURRENT/VOLTAGE

FIG. 8